(19) **Europäisches Patentamt / European Patent Office / Office européen des brevets**

(11) **EP 2 549 842 B1**

(12) # EUROPEAN PATENT SPECIFICATION

(45) Date of publication and mention
of the grant of the patent:
**13.06.2018 Bulletin 2018/24**

(51) Int Cl.:
**H05K 5/00** *(2006.01)*    **F16F 15/00** *(2006.01)*

(21) Application number: **11464008.9**

(22) Date of filing: **20.07.2011**

(54) **Vibration damper for circuit board of automotive control unit**

Vibrationsdämpfer für die Leiterplatte einer Fahrzeugsteuerung

Amortisseur de vibration pour carte de circuit d'une unité de contrôle automobile

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**23.01.2013 Bulletin 2013/04**

(73) Proprietor: **Continental Automotive GmbH
30165 Hannover (DE)**

(72) Inventor: **Tarnovetchi, Marius
300516 Timisoara (RO)**

(56) References cited:
**EP-A1- 1 887 125        DE-A1-102004 046 150
DE-A1-102004 058 675   DE-A1-102008 033 193
FR-A1- 2 677 415          JP-A- 2008 280 713
US-A1- 2003 019 704**

**Description**

The present invention relates to an arrangement. Further, the present invention relates to a vehicle. Furthermore, the present invention relates to a method. Beyond this, the present invention relates to a method of modeling an arrangement for damping a vibration of a circuit board. Moreover, the invention relates to a program element. Furthermore, the invention relates to a computer-readable medium.

Engine Control Units (ECUs) are subject to harsh environments, including vibrations. A Printed Circuit Board (PCB) is the critical part of an ECU from vibration point of view. Any excessive vibration of the PCB will be detrimental for the reliability of the solder joints of the electronic components. Reducing the PCB vibration is the key for improving the ECU reliability over the lifetime from the vibration point of view.

A conventional way to reduce the PCB vibration is based on increasing the PCB stiffness by providing additional fixation screws or adding fixation islands. This concluded in a better PCB fixation to the housing. Stiffening the system leads to higher resonance frequencies which translate to lower displacements for the same acceleration load. The opposite effect is that mode shapes of the PCB and housing overlap, inducing vibrations from the housing to the PCB.

FR 2 677 415 A1 discloses a device which uses two piezoelectric electromechanical transducers and phase-shifting means for detecting a vibration to be damped out and for generating a mechanical wave which compensates, as exactly as possible, for the initial vibration.

DE 102004046150 A1 relates to a device for influencing the vibration of a planar element having two opposite surfaces and a neutral fiber plane running between the two surfaces including at least one actuator and at least one sensor which each are provided with transducer materials and are connected to at least one electronic component or an electronic module. The at least one actuator and at least one sensor are completely integrated in the planar element to be spaced from the two surfaces as well as from the neutral fiber plane.

DE 102008033193 A1 discloses a housing for an engine control unit comprising vibration damping elements.

It is an object of the invention to provide a failure safe system for operating a circuit board under harsh conditions of automotive applications.

This object may be solved by the subject-matter according to the independent claims. Preferred embodiments, which can be used alone or in combination with each other, are presented in the dependent claims.

According to a first aspect of the invention, an arrangement is provided which comprises a circuit board (particularly a printed circuit board, PCB) for an automotive application (particularly any electronic service or task related to an automobile or any other vehicle and being provided by an electronic circuitry of the circuit board) in a vibrating environment (particularly under operating conditions under which the automobile or other vehicle is operated in practice), and a vibration damper (particularly any damping system which actively or passively damps vibrations to which the circuit board, when being mounted in the automobile or other vehicle, is exposed under practical operating conditions) mechanically coupled (particularly having a physical connection therewith) to the circuit board and configured for providing a counterforce (particularly an anti-vibration force configured for inhibiting or counteracting the vibrations of the circuit board) for damping a vibration of the circuit board in the vibrating environment.

According to a second aspect of the invention, a vehicle is provided comprising an arrangement having the above-mentioned features.

According to a further aspect of the invention, an operating method is provided which comprises operating a circuit board for providing an automotive application in a vibrating environment, and providing a counterforce for damping a vibration of the circuit board in the vibrating environment by a vibration damper mechanically coupled to the circuit board.

According to yet another, unclaimed, aspect, a method of modeling (for instance in the context of a, for example computer-assisted, developing process of developing an arrangement of a circuit board and a vibration damper) an arrangement for damping a vibration of a circuit board providing an automotive application in a vibrating environment is provided, wherein the method comprises modeling (for instance by designing a model, for example a parameterized model, of the circuit board) a vibration characteristic of the circuit board (particularly the model includes one or more parameters having an influence on the vibration behavior of the circuit board in an environment in which external vibrations trigger the circuit board to vibrate), modeling (for instance by designing a further model, for example a parameterized model, of the vibration damper to be tuned for vibration suppression) a vibration damping characteristic of a vibration damper (particularly, this further model may include one or more tunable parameters having an influence on the vibration behavior of the circuit board in an environment in which external vibrations trigger the circuit board to vibrate), wherein the vibration damping characteristic is indicative of a vibration damping influence of the vibration damper on the circuit board, wherein the vibration damper is to be (directly or indirectly) mechanically coupled to the circuit board, and tuning (for example modifying, fitting, etc.) at least one vibration-related parameter (such as a mass, a spring constant, a damping parameter) of the modeled vibration damper so that the vibration damper provides a counterforce for damping the vibration of the circuit board in the vibrating environment to meet a target vibration characteristic or a predefined specification of the vibration characteristic of the circuit board (for instance, one or more target values for a desired or an acceptable vibration behavior of the circuit board may be defined, and the tuning may be continued until the modeled vibration damper contributes to the damping of the circuit board to a sufficient extent to allow to fulfil this specification).

According to a further aspect of the invention, a computer-readable medium (for instance a semiconductor memory, a CD, a DVD, a USB stick, a floppy disk or a harddisk) is provided, in which a computer program is stored, which computer program, when being executed by a processor, is adapted to carry out or control the operating method having the above mentioned features.

According to a further aspect of the invention, a program element (for instance a software routine, in source code or in executable code) is provided, which program element, when being executed by a processor, is adapted to carry out or control the operating method having the above mentioned features.

Controlling, which may be performed according to embodiments of the invention, can be realized by a computer program, that is by software, or by using one or more special electronic optimization circuits, that is in hardware, or in hybrid form, that is by means of software components and hardware components.

According to an exemplary embodiment of the invention, a tuned or tunable member or mechanism is added to a circuit board and is adjusted for damping vibrations of the circuit board (for instance of an engine control unit mounted to a vehicle) to which the circuit board may be exposed when the vehicle is operated. The origin of such vibrations may be, for instance, a sinusoidal or basically sinusoidal contribution resulting from a running engine (due to reciprocation of a piston) and a statistical or basically statistical contribution resulting from the vehicle when driving on a road. Particularly, a counterforce (i.e. any mechanical force applied to the circuit board which inhibits or suppresses vibrations coupled to the circuit board from the vibrating environment) is generated by an additional component coupled or connected to the circuit board and which antagonizes the vibrations to be damped or eliminated. Damping such vibrations may render operation of the circuit board (as critical component of an engine control unit) failure robust, since electronic components thereof (for instance solder connections, ceramic components such as resistors, semiconductor components such as a microprocessor, etc.) can be thereby protected against damage and reliability of operation may be improved. The vibration damper may constitute a counterpart to the circuit board and may for instance vibrate - partially or completely - opposite to the circuit board.

In an embodiment, the control of structural vibration may be performed by various fundamental means. These conceptual approaches include modifying rigidities, masses, damping, or shape, and by providing passive or active counterforces. A tuned mass damper (TMD), for instance, is a device consisting of a mass, a spring, and a damping unit that is attached to a structure such as a circuit board in order to reduce the dynamic response of the structure. The frequency of the damper can be tuned to a particular structural frequency so that when that frequency is excited, the damper will resonate out of phase with the structural motion. Energy is dissipated by the damper inertia force acting on the structure.

In an embodiment, a tuned mass damper for a printed circuit board of an engine control unit is provided. The PCB tuned mass damper eliminates the need to over constrain the PCB to the housing. With this decoupling, fewer vibrations are introduced from the housing to the PCB. The PCB vibration is reduced by the oscillation of the mass damper out of phase with the structural motion.

In an embodiment, the vibration damper is configured for vibrating at least partially out of phase with regard to a vibration of the circuit board in the vibrating environment. For instance, the phase difference may be 90° for a particularly strong suppression of vibration of the circuit board.

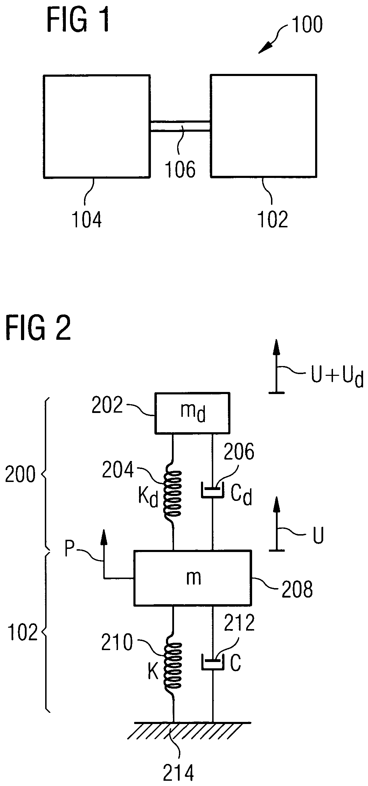

The vibration damper comprises a tuned mass damper having a mass, a spring, and a damping unit and being configured so as to resonate out of phase with regard to the circuit board upon exciting a structural resonance frequency. Such a configuration is for instance realized by the embodiment of Fig. 2. For instance, the mass may be practically realized by a separate solid body (for instance made of metal, plastic, ceramic, etc.) mounted on the circuit board. The mounting position is related to the vibration mode shape that is meant to be eliminated. It may be preferred that the spring and the damping unit are directly mounted on the circuit board and the mass is directly mounted on the spring and the damping unit so that the mass may oscillate relative to the circuit board spaced therefrom via the spring and the damping unit. For instance, the spring and the damping unit may be integrally formed as a common structure. The spring and the damping unit may be practically realized by a soft material block with low stiffness such as dispensed sealing material (for instance silicone) formed on the solid body, since such a material has appropriate properties in terms of flexibility and internal friction. Alternatively, the spring and the

damping unit may be embodied as a spring or a group of springs. Mass value, spring characteristic, and damping behavior are parameters which may be fixedly or variably adjusted so as to obtain a proper suppression of circuit board vibration. As the vibration damper, also the circuit board may be modeled by a further mass, a further spring, and a further damping unit resulting in a corresponding circuit board resonance characteristic different from that of the circuit board. Hence, both vibration damper and circuit board may be described in terms of a mass damper model, and a set of parameters relating to the mass damper model for the vibration damper may be tuned to obtain a desired damping behavior. The out of phase resonance may be a full one (i.e. 90° or basically 90° phase difference between circuit board and vibration damper) , or may be a partial one (for instance with a phase difference between 60° and 120°, particularly between 75° and 105°).

In an embodiment, the vibration damper is configured to be controllable for applying a variable counterforce to the circuit board. For instance, the vibration damper may apply a timely varying counterforce to the circuit board in accordance with a time-dependent control signal applied to the vibration damper. In such an embodiment, vibration of the circuit board may be monitored, and countermeasures may be taken for vibration damping depending on the present value of the detected vibration of the circuit board.

In an embodiment, the vibration damper comprises a feedback control loop having a sensor (particularly one or more sensors such as acceleration sensors, for instance mounted to the circuit board) for sensing information indicative of a vibration of the circuit board, an actuator (such as a movable structure, for instance a bar, which can be moved in response to an applied control signal) for actuating the circuit board to thereby apply the counterforce, and a control unit (such as a processor) for controlling the actuator based on the sensed information. Particularly, the information indicating the present vibration of the circuit board is supplied from the sensor to the control unit which, in turn, calculates a manner according to which the actuator is moved to impact the circuit board for vibration damping purpose.

In an embodiment, the vibration damper comprises both a tuned mass damper having the above mentioned features (i.e. at least a mass, a spring, and a damping unit) and a feedback control loop having the above mentioned features (i.e. at least a sensor, an actuator, and a control unit) . This allows for a refined vibration damping with high accuracy.

In an embodiment, the tuned mass damper and the feedback control loop are provided so as to operate independently from one another. In other words, the tuned mass damper may damp circuit board vibrations, and the feedback control loop may damp circuit board vibrations, without any interaction between the two mechanisms. For instance, different kinds of vibrations may be addressed individually by the two complementary damping mechanisms.

In another embodiment, the tuned mass damper and the feedback control loop are configured so that the actuator actuates the circuit board via the tuned mass damper. In other words, the actuator may directly impact or apply a mechanical force to the mass damper which, in turn, directly transfers the impact force (for instance modified in accordance with its own response characteristic) to the circuit board. In this embodiment, cooperation or interaction between the two mechanisms is possible allowing to render the vibration suppression control even more precise.

For instance, the vibration damper may be configured as a passive member (i.e. free of any control, see for instance embodiment of Fig. 5), an actively controlled member (i.e. to be actively controlled, see for instance embodiment of Fig. 6), a hybrid member combining passive and actively controlled operation (for instance operating independently from one another, see for instance embodiment of Fig. 7), and a semiactive member having an actively controlled passive member (for instance two functionally coupled vibration dampers operating coordinatedly, see for instance embodiment of Fig. 8).

In an embodiment, the arrangement is configured as an engine control unit (ECU) for controlling an engine of a vehicle, the circuit board comprising at least a part of the electronic circuitry of the ECU. An engine control unit, also known as power-train control module (PCM) or engine control module (ECM), may be an electronic control device that provides one or more automotive applications, for instance determines the amount of fuel, ignition timing and other parameters an internal combustion engine needs to keep running. This may be performed by reading values from multidimensional performance maps (so called LUTs), using input values (for instance engine speed) calculated from signals coming from sensor devices monitoring the engine.

According to a further exemplary embodiment, the vehicle may be selected from a group consisting of an automobile, a passenger car, a truck, a bus, a train, an aircraft and a ship. Any vehicles are possible as well.

Further details and advantages of the invention are explained with regard to the enclosed figures. The invention will be described in more detail hereinafter with reference to examples of embodiment .

Figure 1 schematically illustrates an arrangement according to an exemplary embodiment of the invention.

Figure 2 shows a model of a tuned mass damper coupled to a printed circuit board according to an exemplary embodiment of the invention.

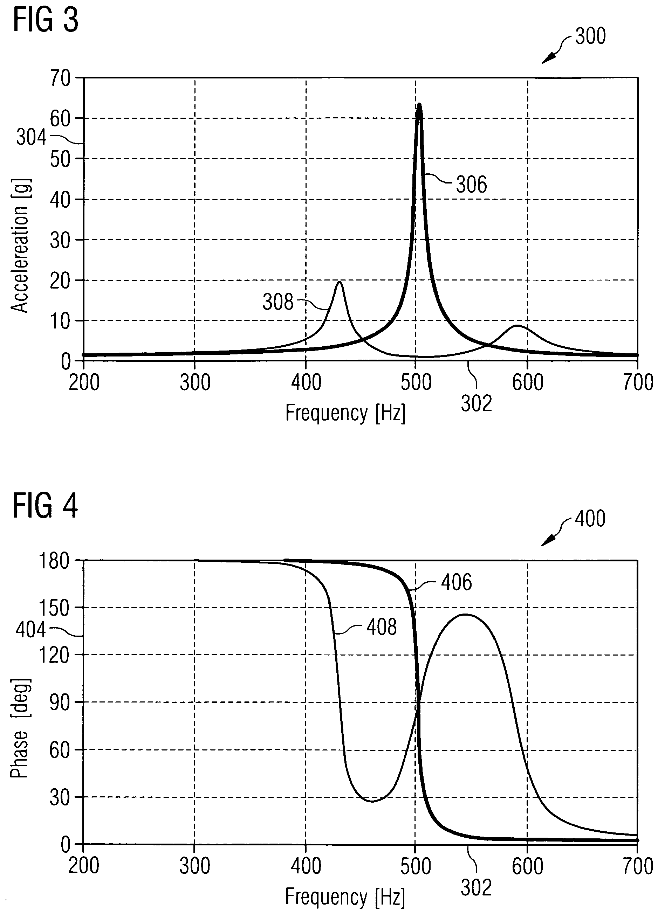

Figure 3 and Figure 4 are diagrams illustrating the effect of a tuned mass damper on the vibration behavior of a circuit board according to an exemplary embodiment of the invention.

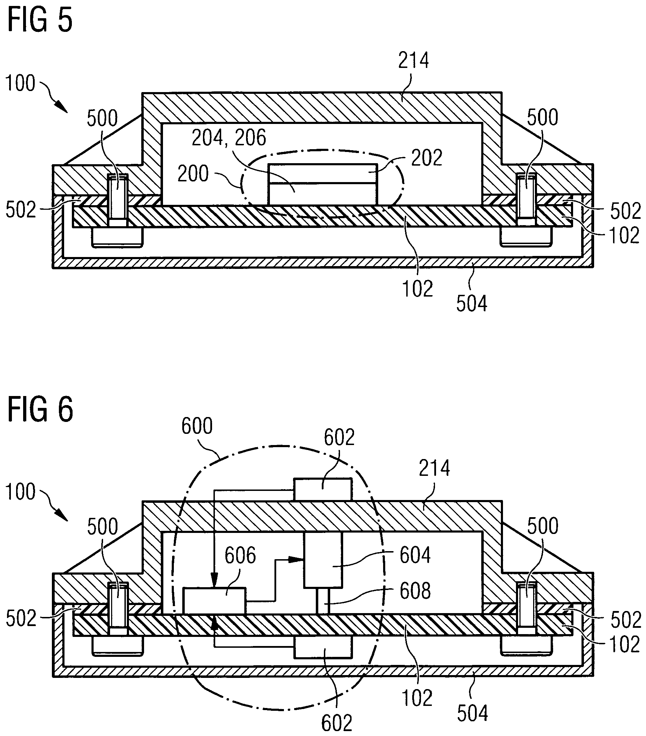

Figure 5 to Figure 8 illustrate vibration damping arrangements according to exemplary embodiments of the invention.

With regard to the following description of the embodiments of the invention the same reference signs refer to the same or comparable components.

Figure 1 illustrates an arrangement 100 according to an exemplary embodiment of the invention and comprises a printed circuit board 102 of an engine control unit for an engine control application in a vibrating environment. As schematically indicated by a coupling structure 106, a vibration damper 104 is mechanically rigidly coupled to the printed circuit board 102. The coupling structure 106 may be a separate coupling body between the printed circuit board 102 and the vibration damper 104, or may indicate a direct coupling between the printed circuit board 102 and the vibration damper 104, i.e. with a direct contact between the printed circuit board 102 and the vibration damper 104. The vibration damper 104 is tuned for providing a counterforce to the printed circuit board 102, i.e. counteracting a vibration force of the printed circuit board 102 for damping a vibration of the circuit board 102 in the vibrating environment. Figure 5 to Figure 8 described below show examples as to how the vibration damper 104 can be structurally embodied.

The concept of implementing a tuned mass damper 200 as a vibration damper according to an embodiment of the invention is illustrated using a two mass model shown in Figure 2. The tuned mass damper 200 (TMD) has a mass 202, a spring 204, and a damping unit 206 interconnected in the manner shown in Figure 2. Moreover, a further mass 208, a further spring 210, and a further damping unit 212 represent a model of the PCB 102 and are interconnected to one another and to the tuned mass damper 200 in the manner shown in Figure 2. Therefore, two mass damper units are coupled to one another in the model of Figure 2, i.e. a tunable one representing the vibration damper 104 of Figure 1 and another one representing the PCB 102. A fixation or housing, in which the tuned mass damper 200 and the PCB 102 are mounted is modeled as reference numeral 214.

The model of Fig. 2 represents a virtual arrangement as a basis for a mathematical or numerical description of the arrangement to be designed. Upon having determined parameter values of this virtual model, a physical or real arrangement as an engine control unit can be constructed by designing the corresponding members 102, 200 in accordance with these parameters.

Referring to the following mathematical description, the subscript d refers to the tuned mass damper 200. The PCB 102 structure is idealized as a single degree of freedom system. The following notation is used:

$\omega$ = radian frequency

$k$ = spring rate

$m$ = mass

$f_n$ = natural frequency

$c$ = viscous damping coefficient

$\xi$ = damping ratio

$$\omega_d = \sqrt{\frac{k_d}{m_d}} \qquad (1)$$

$$f_d = \frac{\omega_d}{2\pi} = \frac{1}{2\pi}\sqrt{\frac{k_d}{m_d}} \qquad (2)$$

$$c = 2\xi\omega_d m_d \qquad (3)$$

$$\omega = \sqrt{\frac{k}{m}} \qquad (4)$$

$$f_n = \frac{\omega}{2\pi} = \frac{1}{2\pi}\sqrt{\frac{k}{m}} \qquad (5)$$

$$c = 2\xi\omega\, m \qquad (6)$$

and defining $\overline{m}$ as the mass ratio:

$$\overline{m} = \frac{m_d}{m} \qquad (7)$$

the governing equations of motion are given by:

- the primary mass:

$$(1+\overline{m})\ddot{u} + 2\xi\omega\dot{u} + \omega^2 u = \frac{p}{m} - \overline{m}\ddot{u}_d \qquad (8)$$

- the tuned mass:

$$\ddot{u}_d + 2\xi_d\omega_d\dot{u}_d + \omega_d^2 u_d = -\ddot{u} \qquad (9)$$

The purpose of adding the mass damper 200 is to limit the motion of the structure when it is subjected to a particular excitation. The design of the mass damper 200 involves specifying the mass, stiffness, and damping coefficient. In this example, an optimal approximation for the frequency of the damper relates to:

$$\omega_d = \omega \qquad (10)$$

The stiffness properties for this frequency combination are related by

$$k_d = \overline{m}k \qquad (11)$$

Equation (10) corresponds to tuning the mass damper 200 to the fundamental period of the PCB 102 structure. Considering a periodic excitation p ($\hat{p}$ is an excitation amplitude, $\Omega$ is a radian frequency of the excitation, t denotes the time)

$$p = \hat{p} \cdot \sin\Omega t \qquad (12)$$

the response is given by:

$$u = \hat{u} \cdot \sin(\Omega t + \delta_1) \qquad (13)$$

$$u_d = \hat{u}_d \cdot \sin(\Omega t + \delta_1 + \delta_2) \qquad (14)$$

where $\hat{u}$ and $\delta$ denote the displacement amplitude and phase shift, respectively.
The critical loading scenario is the resonant condition $\Omega = \omega$. The solution for this case has the following form:

$$\hat{u} = \frac{\hat{p}}{k\overline{m}} \sqrt{\frac{1}{1+\left(\frac{2\xi}{\overline{m}} + \frac{1}{2\xi_d}\right)^2}} \qquad (15)$$

$$\hat{u}_d = \frac{1}{2\xi_d}\hat{u} \qquad (16)$$

$$\tan \delta_1 = -\left(\frac{2\xi}{\bar{m}} + \frac{1}{2\xi_d}\right) \qquad (17)$$

$$\delta_2 = -\frac{\pi}{2} \qquad (18)$$

The response of the tuned mass 202 is 90° out of phase with the response of the primary mass 208. This difference in phase produces the energy dissipation contributed by the damper inertia force.

The response for no damper is given by:

$$\hat{u} = \frac{\hat{p}}{k}\left(\frac{1}{2\xi}\right) \qquad (19)$$

$$\delta_1 = -\frac{\pi}{2} \qquad (20)$$

To compare these two cases, we express Eq. (15) in terms of an equivalent damping ratio:

$$\hat{u} = \frac{\hat{p}}{k}\left(\frac{1}{2\xi_e}\right) \qquad (21)$$

where

$$\xi_e = \frac{\bar{m}}{2}\sqrt{1 + \left(\frac{2\xi}{\bar{m}} + \frac{1}{2\xi_d}\right)^2} \qquad (22)$$

Equation (22) shows the relative contribution of the damper parameters to the total damping. Increasing the mass ratio magnifies the damping. However, since the added mass also increases, there is a practical limit. Decreasing the damping coefficient for the damper also increases the damping. Noting Eq. (16), the relative displacement also increases in this case, and just as for the mass, there is an impact on the relative motion of the damper. Selecting the final design requires a tradeoff between these two constraints. Also to accommodate the displacement of the damper mass is an important design consideration.

Figure 3 illustrates a diagram 300 having an abscissa 302 along which a frequency is plotted. Along an ordinate 304, acceleration is plotted. A first curve 306 relates to a damped single degree of freedom (SDOF) system, whereas a second curve 308 relates to a damped SDOF plus a tuned mass damper TMD.

Figure 4 illustrates a diagram 400 having an abscissa 302 at which the frequency is plotted again. Along an ordinate 404, a phase is plotted. A first curve 406 relates to the damped SDOF, whereas a second curve 408 relates to a damped SDOF plus a (TMD).

The effect of a tuned mass damper is visible in Figure 3 and Figure 4: The TMD is not always necessary to dissipate a large amount of energy. Instead, the TMD can reduce the amount of energy that goes into the system by changing the phase of the vibration. The addition of a TMD, in fact, transforms the lightly damped first mode of the uncontrolled structure into two coupled and highly damped modes of a two degree of freedom (2-DOF) modal system.

Figure 5 illustrates a practical realization of a vibration damping arrangement 100 according to an exemplary embodiment of the invention which can be manufactured based on the result of the previously described modeling using corresponding tuning parameters.

In this embodiment, the vibration damper is a member fulfilling the properties of a tuned mass damper 200 with mass 202 and a functionally combined spring-damper unit 204, 206. In view of the adjusted tuning parameters, the tuned mass damper 200 is configured so as to resonate out of phase with regard to the circuit board 102 upon exciting a vibration at or around a corresponding resonance frequency.

The spring-damper element 204, 206 can be realized by dispensing sealant material used for sealing of cover 504 and connector. Such a sealant material has very good adhesion properties, good damping properties, and by metering the dispensed quantity, the desired spring rate can be adjusted.

In Figure 5, fixation screws 500 are shown for fixing the printed circuit board 102 to the housing 214. The housing 214 and the cover 504 partially or completely enclose the PCB 102. Thermal interface material is denoted with reference numeral 502.

The tuned mass 202 can be realized from any solid material, protected or electrically non-conductive. Guidance to the mass 202 may be added to allow only oscillation in one direction.

A passive control system such as the one shown in Figure 5 does not require an external power source. Passive control devices impart forces that are developed in response to the motion of the structure such as the PCB 102. The energy in a passively controlled structural system, including the passive devices, cannot be increased by the passive control devices guaranteeing stability.

These passive device methods rely on exact tuning and are therefore simple in construction. In contrast to this, an active control system is able to adapt to structural changes and varying usage patterns, which may be advantageous under certain loading conditions.

In comparison with passive control, active control of structural response may rely on the following two features: (a) a certain amount of external power or energy is required; and (b) a decision-making process based on real-time-measured data is involved. In this regard, active control includes a wide range of technologies. In an active control system, an external source powers one or more control actuators that apply forces to the structure in a prescribed manner. These forces can be used to both add and dissipate energy in the structure to achieve a desired, optimized response.

Figure 6 illustrates a corresponding, unclaimed, vibration damping arrangement 100 having such an active control.

In this embodiment, the vibration damper comprises a feedback control loop 600 having two sensors 602 (in this embodiment one of them is attached to a surface of the PCB 102 and the other one is attached to a surface of the housing 214) for sensing acceleration data indicative of a mechanical vibration of the circuit board 102. An actuator 604 of the feedback control loop 600 is provided for actuating the circuit board 102 via an actuating bar 608 for applying the counterforce to the circuit board 102. A control unit 606 of the feedback control loop 600 is provided for controlling the actuator 604 to actuate the circuit board 102 based on the sensed information.

From the control-engineering point of view, the active control systems may have four interconnected components or elements. These components are: the structure to be controlled (PCB 102), the sensors 602, the controller or control unit 606, and one or more actuators 604. Each of these elements works as a subsystem and being mutually integrated such that the output from one component is the input to other components in closed feedback control loop 600.

Hybrid control systems may further increase the overall reliability and efficiency of the actively controlled systems as the one shown in Figure 6. The term "hybrid control" may denote the combined use of an active control system and a passive control system. For example, a structure equipped with distributed viscoelastic damping may be supplemented with an active mass damper, or a base isolated structure with actuators to actively enhance performance. In addition, a hybrid control system is even more reliable than a fully active system, as the passive elements are always effective regardless of the status of the active elements.

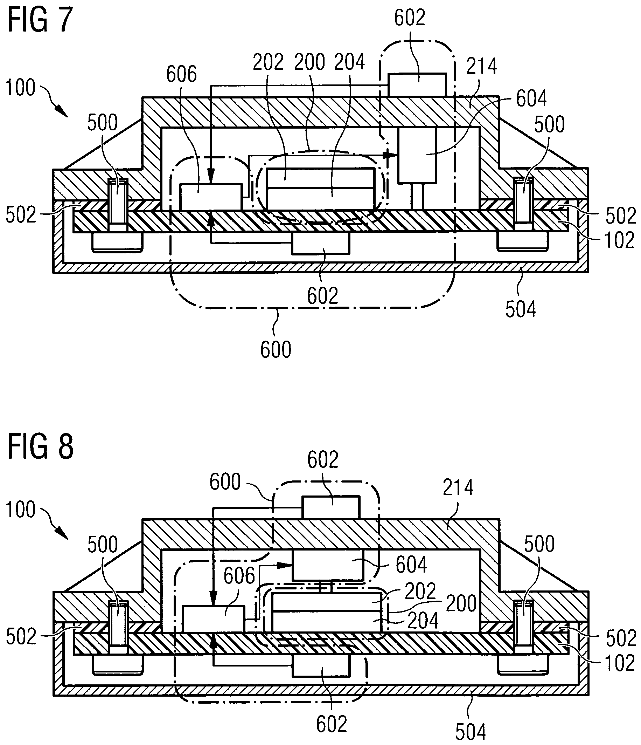

Figure 7 illustrates a vibration damping arrangement 100 as an example for such a hybrid control system according to an exemplary embodiment of the invention.

The embodiment of Figure 7 has both a tuned mass damper 200 with the properties described referring to Figure 5 and a feedback control loop 600 with the properties described referring to Figure 6. In the shown embodiment, tuned mass damper 200 and feedback control loop 600 operate independently without any interaction between these two mechanisms of vibration damping.

Semi-active control systems do not add mechanical energy to the structural system (including the structure and the control actuators), but control the passive devices. More specifically, their actuating force may be produced by an internal mechanism based on external sensor feedback. Because of their low power requirements and large controllable force capacity, semi-active systems are particularly advantageous by offering the reliability of passive devices, while maintaining the versatility and adaptability of fully active systems.

Figure 8 illustrates a vibration damping arrangement 100 as an example for such a semi-active control system according to an exemplary embodiment of the invention.

The embodiment of Figure 8 has both a tuned mass damper 200 with the properties described referring to Figure 5 and a feedback control loop 600 with the properties described referring to Figure 6. In the shown embodiment, tuned mass damper 200 and feedback control loop 600 are operated coordinatedly, wherein interaction between the two mechanisms is provided by the bar 608 of the actuator 604 directly impacting the tuned mass damper 200 which, in turn, directly impacts PCB 102.

It should be noted that the term "comprising" does not exclude other elements or features and the "a" or "an" does not exclude a plurality. Also elements described in association with different embodiments may be combined.

It should also be noted that reference signs in the claims shall not be construed as limiting the scope of the claims.

**Claims**

1. Arrangement (100), the arrangement comprising

    a circuit board (102) for an automotive application in a vibrating environment,
    a vibration damper (104) mechanically coupled to the circuit board (102) and configured for providing a counterforce for damping a vibration of the circuit board (102) in the vibrating environment
    **characterized in that** the vibration damper (104) comprises a tuned mass damper (200) having a mass (202), a spring (204), and a damping unit (206) and is configured so as to resonate out of phase with regard to the circuit board (102).

2. Arrangement (100) according to claim 1, wherein the vibration damper (104) is configured for vibrating at least partially out of phase with regard to a vibration of the circuit board (102) in the vibrating environment.

3. Arrangement (100) according to claim 1 or 2, wherein the vibration damper (104) additionally comprises a feedback control loop (600) having a sensor (602) for sensing information indicative of a vibration of the circuit board (102), an actuator (604) for actuating the circuit board (102) for applying the counterforce, and a control unit (606) for controlling the actuator (604) based on the sensed information.

4. Arrangement (100) according to claim 3, wherein the tuned mass damper (200) and the feedback control loop (600) are provided so as to operate independently from one another.

5. Arrangement (100) according to claim 3, wherein the tuned mass damper (200) and the feedback control loop (600) are configured so that the actuator (604) actuates the circuit board (102) via the tuned mass damper (200).

6. Arrangement (100) according to one of the claims 1 to 5, wherein the vibration damper (104) is configured as one of the group consisting of a passive member, an actively controlled member, a hybrid member combining passive and actively controlled operation, and a semiactive member having an actively controlled passive member.

7. Arrangement (100) according to one of claims 1 to 6, wherein the arrangement (100) is an engine control arrangement.

8. Arrangement (100) according to claim 7, configured as an engine control unit.

9. Vehicle, comprising an arrangement (100) according to one of the claims 1 to 8.

10. An operating method, comprising
    operating a circuit board (102) for providing an automotive application in a vibrating environment,
    providing a counterforce for damping a vibration of the circuit board (102) in the vibrating environment by a vibration damper (104) mechanically coupled to the circuit board (102), wherein the vibration damper (104) comprises a tuned mass damper (200) having a mass (202), a spring (204), and a damping unit (206) and is configured so as to resonate out of phase with regard to the circuit board (102).

11. Operating method according to claim 10, wherein the vibration damper (104) additionally comprises a feedback control loop (600) having a sensor (602) for sensing information indicative of a vibration of the circuit board (102), an actuator (604) for actuating the circuit board (102) for applying the counterforce, and a control unit (606) controlling the actuator (604) based on the sensed information.

12. Computer-readable medium, in which a computer program is stored, which computer program, when being executed by a processor (606), is adapted to control a method according to claim 11.

13. Program element, which program element, when being executed by a processor (606), is adapted to control a method according to claim 11.

**Patentansprüche**

1. Anordnung (100), wobei die Anordnung Folgendes aufweist:

   eine Leiterplatte (102) für eine Automobilanwendung in einer vibrierenden Umgebung,
   einen Vibrationsdämpfer (104), der mechanisch mit der Leiterplatte (102) gekoppelt ist und ausgebildet ist zum Bereitstellen einer Gegenkraft zum Dämpfen einer Vibration der Leiterplatte (102) in der vibrierenden Umgebung, **dadurch gekennzeichnet, dass** der Vibrationsdämpfer (104) einen abgestimmten Massendämpfer (200) mit einer Masse (202), einer Feder (204) und einer Dämpfungseinheit (206) aufweist und dafür ausgebildet ist, um somit hinsichtlich der Leiterplatte (102) phasenverstimmt zu schwingen.

2. Anordnung (100) nach Anspruch 1, wobei der Vibrationsdämpfer (104) ausgebildet ist zum zumindest teilweisen phasenverstimmten Vibrieren hinsichtlich einer Vibration der Leiterplatte (102) in der vibrierenden Umgebung.

3. Anordnung (100) nach Anspruch 1 oder 2, wobei der Vibrationsdämpfer (104) zusätzlich eine Rückkopplungsregelschleife (600), die einen Sensor (602) zum Erfassen von Informationen, die eine Vibration der Leiterplatte (102) anzeigen, einen Aktuator (604) zum Bewegen der Leiterplatte (102) zum Einbringen der Gegenkraft und eine Steuerung (606) zum Steuern des Aktuators (604) auf der Grundlage der erfassten Informationen aufweist.

4. Anordnung (100) nach Anspruch 3, wobei der abgestimmte Massendämpfer (200) und die Rückkopplungsregelschleife (600) so vorgesehen sind, dass sie unabhängig voneinander arbeiten.

5. Anordnung (100) nach Anspruch 3, wobei der abgestimmte Massendämpfer (200) und die Rückkopplungsregelschleife (600) ausgebildet sind, so dass der Aktuator (604) die Leiterplatte (102) über den abgestimmten Massendämpfer (200) bewegt.

6. Anordnung (100) nach einem der Ansprüche 1 bis 5, wobei der Vibrationsdämpfer (104) als einer aus der Gruppe ausgebildet ist, die aus einem passiven Element, einem aktiv gesteuerten Element, einem passiven und aktiven gesteuerten Betrieb kombinierenden Hybridelement und einem semiaktiven Element, das ein aktiv gesteuertes passives Element aufweist, besteht.

7. Anordnung (100) nach einem der Ansprüche 1 bis 6, wobei die Anordnung (100) eine Motorsteuerungsanordnung ist.

8. Anordnung (100) nach Anspruch 7, die als eine Motorsteuerungsanordnung ausgebildet ist.

9. Fahrzeug, das eine Anordnung (100) nach einem der Ansprüche 1 bis 8 aufweist.

10. Betriebsverfahren, aufweisend
    Betreiben einer Leiterplatte (102) zum Bereitstellen einer Automobilanwendung in einer vibrierenden Umgebung,
    Bereitstellen einer Gegenkraft zum Dämpfen einer Vibration der Leiterplatte (102) in der vibrierenden Umgebung durch einen mechanisch mit der Leiterplatte (102) gekoppelten Vibrationsdämpfer (104), wobei der Vibrationsdämpfer (104) einen abgestimmten Massendämpfer (200) mit einer Masse (202), einer Feder (204) und einer Dämpfungseinheit (206) aufweist und dafür ausgebildet ist, um somit hinsichtlich der Leiterplatte (102) phasenverstimmt zu schwingen.

11. Betriebsverfahren nach Anspruch 10, wobei der Vibrationsdämpfer (104) zusätzlich eine Rückkopplungsregelschleife (600) mit einem Sensor (602) zum Erfassen von Informationen, die eine Vibration der Leiterplatte (102) anzeigen, einem Aktuator (604) zum Bewegen der Leiterplatte (102) zum Einbringen der Gegenkraft und einer Steuerung (606) zum Steuern des Aktuators (604) auf der Grundlage der erfassten Informationen aufweist.

12. Computerlesbares Medium, in welchem ein Computerprogramm gespeichert ist, wobei das Computerprogramm, wenn es durch einen Prozessor (606) ausgeführt wird, ausgebildet ist zum Steuern eines Verfahrens nach Anspruch 11.

13. Programmelement, wobei das Programmelement, wenn es durch einen Prozessor (606) ausgeführt wird, ausgebildet ist zum Steuern eines Verfahrens nach Anspruch 11.

**Revendications**

1.  Agencement (100), l'agencement comprenant
    une carte de circuit imprimé (102) pour une application automobile dans un environnement vibrant,
    un amortisseur de vibrations (104) couplé mécaniquement à la carte de circuit imprimé (102) et configuré pour fournir une contre-force pour amortir une vibration de la carte de circuit imprimé (102) dans l'environnement vibrant **caractérisé en ce que** l'amortisseur de vibrations (104) comprend un amortisseur à masse accordé (200) ayant une masse (202), un ressort (204) et une unité d'amortissement (206) et est configuré pour résonner en déphasage par rapport à la carte de circuit imprimé (102).

2.  Agencement (100) selon la revendication 1, dans lequel l'amortisseur de vibrations (104) est configuré pour vibrer au moins partiellement en déphasage par rapport à une vibration de la carte de circuit imprimé (102) dans l'environnement vibrant.

3.  Agencement (100) selon la revendication 1 ou 2, dans lequel l'amortisseur de vibrations (104) comprend en outre une boucle de commande à rétroaction (600) comportant un capteur (602) pour détecter des informations indiquant une vibration de la carte de circuit imprimé (102), un actionneur (604) pour actionner la carte de circuit imprimé (102) pour appliquer la contre-force, et une unité de commande (606) pour commander l'actionneur (604) sur la base des informations détectées.

4.  Agencement (100) selon la revendication 3, dans lequel l'amortisseur à masse accordé (200) et la boucle de commande à réaction (600) sont prévus de façon à fonctionner indépendamment l'un de l'autre.

5.  Agencement (100) selon la revendication 3, dans lequel l'amortisseur à masse accordé (200) et la boucle de commande à rétroaction (600) sont configurés de sorte que l'actionneur (604) actionne la carte de circuit imprimé (102) par l'intermédiaire de l'amortisseur à masse accordé (200).

6.  Agencement (100) selon l'une des revendications 1 à 5, dans lequel l'amortisseur de vibrations (104) est configuré comme étant l'un du groupe constitué d'un élément passif, d'un élément commandé activement, d'un élément hybride combinant un fonctionnement passif et commandé activement, et d'un élément semi-actif ayant un élément passif commandé activement.

7.  Agencement (100) selon l'une des revendications 1 à 6, dans lequel l'agencement (100) est un agencement de commande de moteur.

8.  Agencement (100) selon la revendication 7, configuré en tant qu'unité de commande de moteur.

9.  Véhicule, comprenant un agencement (100) selon l'une des revendications 1 à 8.

10. Procédé de fonctionnement, comprenant de
    faire fonctionner une carte de circuit imprimé (102) pour fournir une application automobile dans un environnement vibrant,
    fournir une contre-force pour amortir une vibration de la carte de circuit (102) dans l'environnement vibrant par un amortisseur de vibrations (104) couplé mécaniquement à la carte de circuit imprimé (102), dans lequel l'amortisseur de vibrations (104) comprend un amortisseur à masse accordé (200) comportant une masse (202), un ressort (204), et une unité d'amortissement (206), et est configuré de manière à résonner en déphasage par rapport à la carte de circuit imprimé (102).

11. Procédé de fonctionnement selon la revendication 10, dans lequel l'amortisseur de vibrations (104) comprend en outre une boucle de commande à rétroaction (600) comportant un capteur (602) pour détecter des informations indiquant une vibration de la carte de circuit imprimé (102), un actionneur (604) pour actionner la carte de circuit imprimé (102) pour appliquer la contre-force, et une unité de commande (606) commandant l'actionneur (604) sur la base des informations détectées.

12. Support lisible par ordinateur, sur lequel un programme d'ordinateur est stocké, lequel programme d'ordinateur, lorsqu'il est exécuté par un processeur (606), est conçu pour commander un procédé selon la revendication 11.

13. Élément de programme, lequel élément de programme, lorsqu'il est exécuté par un processeur (606), est conçu pour commander un procédé selon la revendication 11.

## FIG 1

100

104    106    102

## FIG 2

202  $m_d$

$U+U_d$

200

204  206
$K_d$  $C_d$

P  $U$

$m$  208

102

210  212
$K$  $C$

214

## FIG 3

## FIG 4

FIG 5

FIG 6

**FIG 7**

**FIG 8**

**EP 2 549 842 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2677415 A1
- DE 102004046150 A1
- DE 102008033193 A1